(19) Europäisches Patentamt
European Patent Office
Office européen des brevets

(11) **EP 1 573 488 B1**

(12) **EUROPÄISCHE PATENTSCHRIFT**

(45) Veröffentlichungstag und Bekanntmachung des Hinweises auf die Patenterteilung:
**27.02.2008 Patentblatt 2008/09**

(21) Anmeldenummer: **04790732.4**

(22) Anmeldetag: **21.10.2004**

(51) Int Cl.:
***G06F 1/03*** (2006.01)     ***H03L 7/185*** (2006.01)

(86) Internationale Anmeldenummer:
**PCT/EP2004/011932**

(87) Internationale Veröffentlichungsnummer:
**WO 2005/048089 (26.05.2005 Gazette 2005/21)**

(54) **FREQUENZSYNTHESIZER NACH DEM DIREKTEN DIGITALEN SYNTHESE-VERFAHREN**

DIRECT DIGITAL FREQUENCY SYNTHESIZER

SYNTHÉTISEUR DE FRÉQUENCE BASÉ SUR LE PROCÉDÉ DE SYNTHÈSE NUMÉRIQUE DIRECTE

(84) Benannte Vertragsstaaten:
**DE FR GB**

(30) Priorität: **05.11.2003 DE 10351604**

(43) Veröffentlichungstag der Anmeldung:
**14.09.2005 Patentblatt 2005/37**

(73) Patentinhaber: **Rohde & Schwarz GmbH & Co. KG**
**81671 München (DE)**

(72) Erfinder: **KLAGE, Günther**
**85604 Zorneding (DE)**

(74) Vertreter: **Körfer, Thomas**
**Mitscherlich & Partner**
**Patent- und Rechtsanwälte**
**Postfach 33 06 09**
**80066 München (DE)**

(56) Entgegenhaltungen:
**EP-A- 0 823 700**     **WO-A-03/044959**
**US-A- 4 901 265**     **US-A1- 2002 057 733**
**US-A1- 2003 118 143**

- **LEYONHJELM S A ET AL: "AN EFFICIENT IMPLEMENTATION OF BANDLIMITED DITHERING" WIRELESS PERSONAL COMMUNICATIONS, KLUWER ACADEMIC PUBLISHERS, NL, Bd. 8, Nr. 1, August 1998 (1998-08), Seiten 31-35, XP000765354 ISSN: 0929-6212**
- **REINHARDT V ET AL: "A SHORT SURVEY OF FREQUENCY SYNTHESIZER TECHNIQUES" PROCEEDINGS OF THE ANNUAL FREQUENCY CONTROL SYMPOSIUM. PHILADELPHIA, PENNSYLVANIA, 1986, NEW YORK, IEEE, US, Bd. SYMP. 40, 28. Mai 1986 (1986-05-28), Seiten 355-365, XP000565101**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung betrifft einen Frequenzsynthesizer nach dem direkten digitalen Synthese-Verfahren mit einer Unterdrückungsmöglichkeit von Nebenlinien im Frequenzspektrum des Ausgangsfrequenzsignals.

Heutige hochauflösende breitbandige Frequenzsynthesizer basieren im wesentlichen auf zwei verschiedenen Verfahren, dem Fraktional-N-Verfahren und dem direkten digitalen Synthese-Verfahren

Die Einstellung der Frequenz beim Fraktional-N-Verfahren erfolgt durch definierte Frequenzteilung der Referenzfrequenz in einem dem Phasenregelkreis vorgelagerten Vorwärtszweig oder der Ausgangsfrequenz des Phasenregelkreises im Rückkopplungszweig des Phasenregelkreises über jeweils einen programmierbaren Frequenzteiler. Der Frequenzteiler arbeitet digital über Sigma-Delta-Modulation eines als Referenzfrequenzwert dienenden Digitalwortes. Durch die Verwendung hoher Teilungsfaktoren im Frequenzteiler des Rückkopplungszweiges kann ein Phasenregelkreis mit hohen Frequenzen realisiert werden. Hohe Teilungsfaktoren bewirken aber eine deutliche Erhöhung des Phasenrauschens des Phasenregelkreises (Phasenrauschen des Phasenregelkreises = 20 * log (Teilungsfaktor des Ausgangsfrequenz-Teilers)). Zudem erzeugt der Sigma-Delta-Modulator ein vom Träger weg ansteigendes Quantisierungsgeräusch, was durch die PLL unbedingt unterdrückt werden muß. Die Dämpfung des erhöhten Phasenrauschens bzw. des ansteigenden Quantisierungsrauschens mittels Tiefpaßcharakteristik des Phasenregelkreises wird mit einer schlechteren Führungsdynamik des Phasenregelkreises (höhere Einschwingzeit aufgrund reduzierter Bandbreite des Phasenregelkreises) erkauft. Maximal realisierbare Regelbandbreiten liegen nach dem aktuellen Stand der Technik bei einigen kHz. Zusätzlich weist das Fraktional-N-Verfahren ein vergleichsweise schlechtes Einschwingverhalten auf, da der Algorithmus des Fraktional-N-Verfahrens sich integrierend dem Optimum nähert. Schließlich besitzt das Frequenzspektrum der Ausgangsfrequenz als weiteren Nachteil des Fraktional-N-Verfahrens Nebenlinien, die bei Teilung des Ausgangsfrequenzsignals durch den Fraktional-N-Frequenzteiler im Rückkopplungszweig des Phasenregelkreises mit einem Teilungsfaktor, der in der Nähe eines ganzzahligen Teilungsfaktors liegt, entstehen (so genannte "Fractional-N-Nebenlinien").

Ein Vorteil des Phasenregelkreises liegt in der Tatsache, daß er vergleichsweise kostengünstig realisiert werden kann und von daher vor allem bei Anwendungen im Niedrigpreis-Segment Verwendung findet. Das Verfahren der direkten digitalen Frequenzsynthese weist die oben genannten Nachteile nicht auf und wird deshalb vor allem bei schnell einschwingenden und phasenrauscharmen Frequenzsynthesizern eingesetzt.

Ein Frequenzsynthesizer nach dem Verfahren der direkten digitalen Synthese besteht gemäß der EP 0 469 233 A2 aus einem Phasenakkumulator, der im Takt einer Referenzfrequenz die Phase eines Phasensignals zyklisch um Phaseninkremente, die in einem Frequenzwort am Eingang des Phasenakkumulators eingestellt werden können, inkrementiert. Eine dem Phasenakkumulator nachfolgende Speichereinheit mit einer abgespeicherten Tabelle von Sinusfunktionswerten führt die zu den jeweiligen Phasenwerten des zyklischen Phasensignals gehörigen Sinusfunktionswerte im Takt der Referenzfrequenz als zeitdiskrete Funktionsfolge einem Digital-Analog-Wandler zu. Im Anschluß an die Digital-Analog-Wandlung erfolgt eine Glättung durch einen Anti-Aliasing-Tiefpaß zum gewünschten sinusförmigen Frequenzsignal.

Nachteilig an direkten digitalen Frequenzsynthesizern ist die Entstehung von sehr trägernahen Nebenlinien im Frequenzspektrum. Erscheinen diese in der Nähe des Nutzsignals können diese Nebenlinien im Frequenzspektrum durch einen nachgeschalteten Phasenregelkreis mit optimierter Bandbreite nicht ausgeregelt werden. Folgende Gründe für die Entstehung derartiger Nebenlinien im Frequenzspektrum der Ausgangsfrequenz können, auch in Anlehnung an den Fachartikel Zs. Papay, "Numerical Distortion in Single-Tone DDS", IEEE-Instrumentation and Measurement Technology Conference, Budapest, May 21-23, 2001 angegeben werden:

• Nebenlinien durch eingeschränkte Phasenauflösung des Phasensignals in der Sinustabelle der Speichereinheit:

Aufgrund begrenzter Speicherkapazität der Speichereinheit werden bei der Adressierung der die Sinustabelle enthaltenden Speicherzellen nicht alle Bits des Phasensignals benutzt. Durch eine Beschränkung auf die höherwertigen Bits des Phasensignals wird die Anzahl der verwendeten Phasenstützwerte pro Sinusschwingung entsprechend einer geringeren Auflösung der Phasenstützwerte deutlich reduziert. Dies führt zu einem sägezahnförmigen Phasenfehler zwischen den optimal mit einem beispielsweise 32 Bit breiten Phasensignal-Datenwort realisierbaren Phasenstützwerten und den tatsächlich verwendeten Phasenstützwerten. Diese Periodizität im Phasenfehler, die einer Phasenmodulation entspricht, führt zu diskreten Nebenlinien um die Trägerfrequenz im Frequenzspektrum der erzeugten Ausgangsfrequenz.

• Nebenlinien durch zu geringe Amplitudenauflösungen des Digital-/Analog-Wandlers:

Die Quantisierung der zeitdiskreten Sinusfunktionswerte für einen vorgegebenen Phasenwert verursacht einen Amplitudenfehler, der von der Auflösung der Quantisierung (Anzahl der Bits für die Quantisierung des Amplitudenwertes) abhängig ist. Durch diese Quantisierung des Amplitudenwertes wird ein Amplitudenfehler von $\Delta A$ = $1/(2^A \cdot \sqrt{12})$ verursacht, unter der Annahme, daß Rundungsfehler gleichmäßig im Bereich $\pm$ ½ LSB verteilt sind (A = Anzahl der Bits des D/A-Wandlers). Ist die Länge des Phasenakkumulators ein ganzzahliges Vielfaches des Frequenzwortes, so wiederholen sich die Phasenwerte periodisch und der zu jedem Phasen- und Amplitudenwert gehörige Quantisierungsfehler weist einen periodischen Verlauf auf, der zu höherwertigen Harmonischen (= Nebenlinien) im Frequenzspektrum führt. Bei fehlender Periodizität der Phasen- und damit der Amplitudenwerte bei nicht ganzzahligem Verhältnis zwischen Frequenzwort und Länge des Phasenakkumulators können an Stelle der höherwertigen Harmonischen, Störlinien im gesamten Frequenzspektrum entstehen.

• Nebenlinien aufgrund von Nichtlinearitäten in der Übertragungskennlinie des Digital-/Analog-Wandlers:

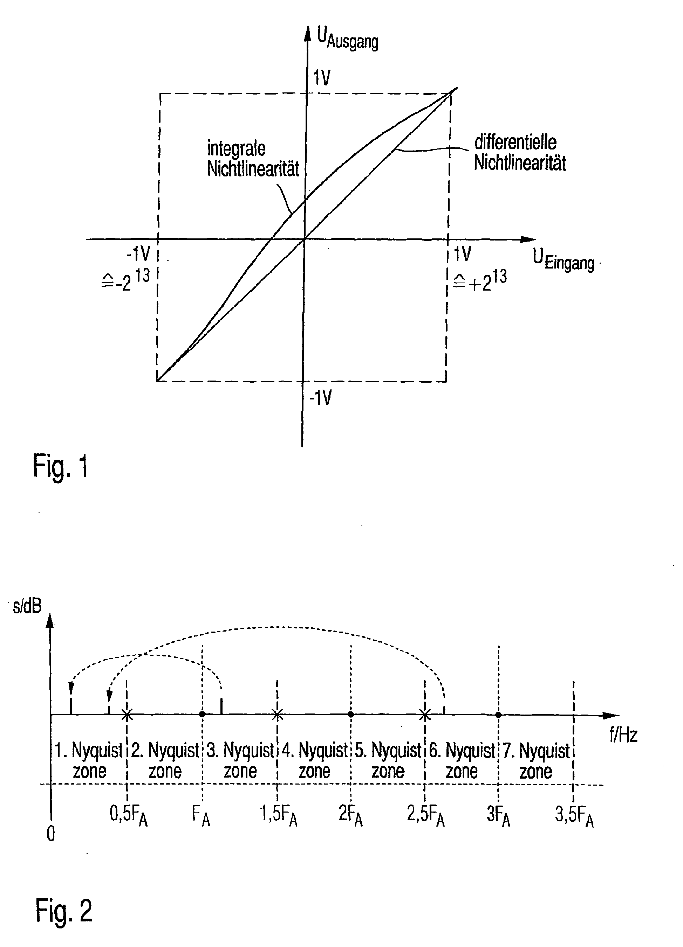

Gemäß Fig. 1 weist die Übertragungskennlinie eines Digital-/Analog-Wandlers gegenüber einem ideal-linearen Verlauf im allgemeinen eine Nichtlinearität im Verlauf auf, die in Fig. 1 stark übertrieben dargestellt ist. Hierbei kann es sich um eine Nichtlinearität handeln, die sich über den gesamten Pegelbereich erstreckt (so genannte integrale Nichtlinearität) oder nur eine Abweichung von der theoretischen Wertedifferenz für den Übergang zwischen zwei Zuständen des Analog-/-DigitalWandlers (so genannte differenzielle Nichtlinearität). Diese Nichtlinearitäten sind auf Unsymmetrien im internen Aufbau des Digital-/Analog-Wandlers (z.B. Unsymmetrien bei Differenzverstärken, Stromquellen, Widerstandsketten usw.) zurückzuführen. Nichtlinearitäten im Übertragungsverhalten führen bei harmonischer Anregung zur Erzeugung von Oberwellen, die wiederum Nebenlinien im Frequenzspektrum der Ausgangsfrequenz darstellen. Da es sich um ein abgetastetes System handelt, kann es zu Aliasing kommen. Diese Aliasing-Effekte führen gemäß Fig. 2 dazu, daß harmonische Nebenlinien oberhalb der 1. Nyquist-Zone in entsprechende nichtharmonische Nebenlinien innerhalb der 1. Nyquist-Zone gefaltet werden können. Problematisch ist, daß derartige nichtharmonische Nebenlinien in der 1. Nyquist-Zone sehr nahe an der Trägerfrequenz zu liegen kommen können. Während die harmonischen Nebenlinien mittels Tiefpaß- Filterung beseitigt werden können, ist dies bei den nichtharmonischen Nebenlinien nahe des Trägers kein gangbarer Weg.

• Nebenlinien aufgrund des nicht idealen dynamischen Verhaltens des Digital-/Analog-Wandlers:

Ab einer gewissen Abtastfrequenz treten verstärkt dynamische Effekte gegenüber den im vorigen Abschnitt beschriebenen statischen Effekten im Übertragungsverhalten des Digital-/Analog-Wandlers in den Vordergrund. Hierbei handelt es sich hauptsächlich um unterschiedliche Anstiegs- und Abfallzeiten sowie um unterschiedliches Überschwingen bei mehrfach verzögerndem Übertragungsverhalten in der Phase des Abtastens und Haltens der zeitdiskreten sinusförmigen Stützwerte ("Glitches"). Diese dynamischen Störeffekte sind auf Unsymmetrien und Fehlanpassungen in der internen Struktur des Digital-/Analog-Wandlers (z. B. fehlangepaßte RC-Glieder, unterschiedliche Schaltzeiten sowie fehlende Synchronität einzelner Logikeinheiten usw.) zurückzuführen. Da diese dynamischen Störeffekte periodisch auftreten, entstehen im Frequenzspektrum ebenso unerwünschte Oberwellen (= Nebenlinien), die ab einer bestimmten Frequenz im Vergleich zu den Nebenlinien der zuvor genannten Gründe dominierend sind. Eine Minimierung dieser dynamischen Unregelmäßigkeiten durch ein zusätzliches Abtasten und Halten unter Ausnutzung des dadurch realisierten Glättungseffektes scheidet insbesondere bei höheren Abtastfrequenzen aus, da die Abtastperiode dann kleiner als die Einschwingzeit werden kann.

Das Entstehen von Nebenlinien aufgrund eingeschränkter Phasen- und Amplitudenauflösung ist heute weitestgehend beherrschbar. Während eine erhöhte Phasenauflösung beispielsweise über fortgeschrittene Interpolationsalgorithmen realisiert werden kann, ist eine erhöhte Amplitudenauflösung bei heutigen Digital-/Analog-Wandlern mit 14 Bit Datenwortbreite selbst im oberen Taktfrequenzbereich von 100 MHz und darüber kein wesentliches Problem mehr. Nebenlinien aufgrund von Nichtlinearitäten in der Übertragungskennlinie sowie aufgrund von dynamischen Asymmetrien des Digital-/Analog-Wandlers stellen aber bei heutigen direkten digitalen Frequenzsynthesizern ein noch ungelöstes Problem dar.

US 4,901,265 offenbart ein Verfahren zum Reduzieren eines Ausgangsrauschens in digitalen Frequenzsynthesizern, bei dem zufälliges oder pseudo-zufälliges Rauschen einem sinusförmigen Datensignal überlagert wird.

US 2002/057733 A1 offenbart einen Frequenzübersetzer mit einem Cordic-Rotationselement, bei dem einem gerundeten Datensignal ein bandbegrenztes Rauschsignal überlagert wird.

Der Erfindung liegt daher die Aufgabe zugrunde, den Frequenzsynthesizer nach dem direkten digitalen Synthese-Verfahren mit den Merkmalen gemäß dem Oberbegriff von Anspruch 1 derart weiterzubilden, daß Nebenlinien im Frequenzspektrum gegenüber dem Signalpegel des Trägers über einen möglichst weiten Ausgangsfrequenzbereich weitest möglich gedämpft werden.

Die Aufgabe der Erfindung wird durch einen Frequenzsynthesizer nach dem direkten digitalen Synthese-Verfahren mit den kennzeichnenden Merkmalen des Anspruchs 1 gelöst.

Die Nebenlinien im Frequenzgang des Frequenzsynthesizers stellen höherwertige harmonische Anteile im Ausgangsfrequenzsignal dar. Zur Beseitigung oder zumindest zur Dämpfung dieser Nebenlinien müssen folglich diese höherfrequenten Periodizitäten im Ausgangsfrequenzsignal aufgelöst werden. Die einfachste Möglichkeit, aus einem Signal mit periodischen Signalanteilen ein unperiodisches Signal zu generieren, ist die Überlagerung mit einem unperiodischen Signal. Ein unperiodisches Signal weist einen stochastischen Signalverlauf auf. Ein Rauschsignal ist ein Signal mit einer derartigen Signalverlaufscharakteristik. In dem erfindungsgemäßen Frequenzsynthesizer wird deshalb den zeitdiskreten Sinusfunktionwerten vor der Digital-Analog-Wandelung ein Rauschsignal überlagert, womit die Nebenlinien im Nutz-Frequenzband des Frequenzsignals gegenüber dem Signalpegel des Trägers deutlich reduziert werden. Dieses Verfahren kann von dem erfindungsgemäßen Frequenzsynthesizer über einen sehr weiten Frequenzbereich realisiert werden.

Vorteilhafte Ausgestaltungen der Erfindung sind in den abhängigen Ansprüchen angegeben.

An das Frequenzspektrum des Rauschsignals werden mehrere Anforderungen gestellt. Einerseits ist ein möglichst hoher Signal-Rausch-Abstand im Frequenzbereich des Nutzsignalbandes, das sich theoretisch bis zur Nyquist-Grenze erstrecken kann, anzustreben. Der erfindungsgemäße Frequenzsynthesizer dämpft das Rauschen im Nutzsignalband - Frequenzbereich beispielsweise zwischen ca. 16 bis 28 MHz bei einer Taktfrequenz von 100 MHz - vergleichsweise gleichmäßig. Zusätzlich ist dafür zu sorgen, daß der Gleichanteil sowie die tiefstfrequenten Bereiche des Frequenzspektrums des Rauschsignals weitestgehend verschwinden, da andernfalls bei der Digital-Analog-Wandelung durch Intermodulation der tiefstfrequenten Rauschanteile mit dem Träger Nebenlinien im Frequenzspektrum entstehen, die sehr nahe an der Trägerfrequenz liegen. Diese führen zu einer unnötigen zusätzlichen Verschlechterung des Signal-Rausch-Abstandes im Nutzband. Schließlich ist auf ein weitestgehend rauschfreies Frequenzspektrum im hoch- und höchstfrequenten Bereich zu achten. All diese Anforderungen an das Frequenzspektrum des Rauschsignals werden durch eine Bandpaßfilterung des weißen Rauschsignals im Niederfrequenzbereich unterhalb des Nutzsignalbandes mittels einer Serienschaltung zweier nicht-rekursiver Filter und eines Differenzieres verwirklicht.

Zur Erzeugung eines möglichst idealen weißen Rauschsignals wird ein Rauschgenerator aus zwei parallel geschalteten Pseudonoisegeneratoren mit einer kombinatorischen Logik zur Verknüpfung der beiden Pseudonoisegenerator-Rauschsignale verwendet. Auf diese Weise wird die Periodizität eines Pseudonoisegenerator-Rauschsignals auf ein Vielfaches erhöht.

Ein dem direkten digitalen Frequenzsynthesizer nachfolgender Phasenregelkreis sorgt für eine Umsetzung der vom Frequenzsynthesizer erzeugten Referenzfrequenz - beispielsweise im Frequenzbereich zwischen 16 und 28 MHz - in den Hochfrequenzbereich von beispielsweise 900 MHz bis 1,8 GHz. Zusätzlich sorgt der Phasenregelkreis aufgrund seiner Tiefpaßcharakteristik für eine zusätzliche Dämpfung der Spektralanteile, die weiterab um das Frequenzsignal liegen und die vom Anti-Aliasing-Tiefpaßfilter im Anschluß an die Digital-Analog-Wandelung nicht vollständig beseitigt wurden.

Ein Ausführungsbeispiel der Erfindung ist in der Zeichnung dargestellt und wird nachfolgend näher beschrieben. Es zeigen:

Fig. 1     eine grafische Darstellung einer idealen und realen Übertragungskennlinie eines Digital-Analog-Wandlers;

Fig. 2     eine grafische Darstellung eines Frequenzspektrums eines abgetasteten Systems mit Aliasing-Effekten;

Fig. 3     ein Schaltbild eines direkten digitalen Frequenzsynthesizers nach dem Stand der Technik;

Fig. 4     ein Schaltbild eines erfindungsgemäßen direkten digitalen Frequenzsynthesizers;

Fig. 5     ein Schaltbild eines erfindungsgemäß verwendbaren Rauschgenerators;

Fig. 6     ein Detail-Schaltbild des PseudonoiseRauschgenerators in Fig. 5;

Fig. 7     eine grafische Darstellung des Frequenzspektrums eines erfindungsgemäß verwendbaren Rauschgenerators;

Fig. 8     eine grafische Darstellung eines Ausgangssignals eines direkten digitalen Frequenzsynthesizers nach dem Stand der Technik;

Fig. 9     eine grafische Darstellung eines Ausgangssignals eines erfindungsgemäßen direkten digitalen Frequenzsynthesizers;

Fig. 10     ein Schaltbild eines erfindungsgemäßen Frequenzsynthesizers bestehend aus einem direkten digitalen Frequenzsynthesizer mit nach geschalteten erfindungsgemäßen Phasenregelkreis;

Fig. 11     eine graphische Darstellung eines Ausgangssignals eines Frequenzsynthesizers, bestehend aus einem direkten digitalen Frequenzsynthesizers nach dem Stand der Technik und eines nachgeschalteten Phasenregelkreises und

Fig. 12     eine grafische Darstellung eines Ausgangssignals eines Frequenzsynthesizers, bestehend aus einem erfindungsgemäßen Frequenzsynthesizer und einem nachgeschalteten Phasenregelkreis.

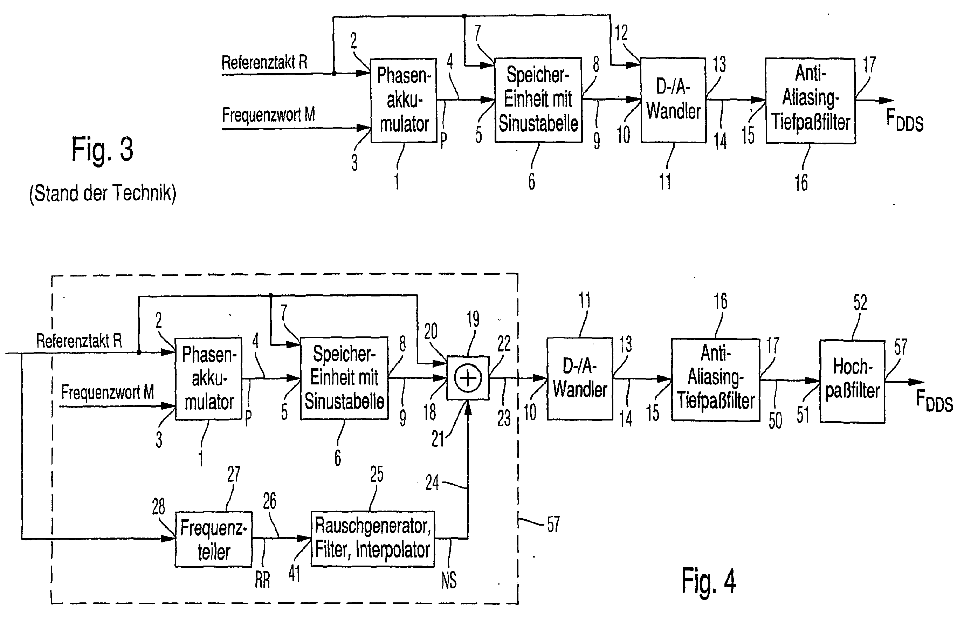

Der erfindungsgemäße direkte digitale Frequenzsynthesizer wird in einer Ausführungsform nachfolgend ausgehend von einem direkten digitalen Frequenzsynthesizer nach dem Stand der Technik in Fig. 3 unter Bezugnahme auf Fig. 4, 5, 6 sowie 11 dargestellt.

Der direkte digitale Frequenzsynthesizer nach dem Stand der Technik in Fig. 3 besteht aus einem Phasenakkumulator 1, der an seinem ersten Eingang 2 von einem Referenztakt R getaktet wird. Im Referenztakt R inkrementiert der Phasenakkumulator 1 seinen internen Zähler um ein Phaseninkrement, das im Frequenzwort M vorgegeben wird und ihm über seinen zweiten Eingang 3 zugeführt wird. Der Maximalstand des internen Zählers ist durch dessen Bitanzahl NB bestimmt und beträgt $2^{NB-1}$. Wird der Maximalstand $2^{NB-1}$ des internen Zählers durch den Vorgang des Phaseninkrementierens erreicht, so beginnt der interne Zähler wieder von neuem zu inkrementieren und ein zyklischer Inkrementiervorgang mit dem vorgegebenen Phaseninkrement setzt sich fort. Somit wird durch den Phasenakkumulator 1 ein zeitdiskretes zyklisches Phasensignal P generiert, das eine Frequenz $f_0$ gemäß der Beziehung (1) aufweist:

$$f_0 = M * R / 2^{NB} \hspace{4cm} (1)$$

Über die Verbindungsleitung 4 wird dieses zeitdiskrete zyklische Phasensignal P des Phasenakkumulators 1 an den ersten Eingang 5 einer Speichereinheit 6, deren Speicherzellen eine Tabelle mit Sinusfunktionswerten beinhalten, zugeführt. Das vollständige aktuelle Phasenwort oder ein Ausschnitt des aktuellen Phasenwortes des zeitdiskreten zyklischen Phasensignals P wird als Adresse für die Speicherzelle herangezogen, in der der zur Phase gehörige Sinusfunktionswert abgespeichert ist. Nach Adressierung der jeweiligen Speicherzelle der Speichereinheit 6 wird der zur aktuellen Phase korrespondierende Sinusfunktionswert taktsynchron zum am zweiten Eingang 7 anliegenden Referenztakt R ausgelesen und am Ausgang 8 ausgegeben. Am Ausgang 8 der Speichereinheit 6 liegt folglich über die Zeit betrachtet eine Folge von zeitdiskreten Sinusfunktionswerten an.

Über die Verbindungsleitung 9 wird diese Folge von zeitdiskreten Sinusfunktionswerten an den ersten Eingang 10 eines Digital-/Analog-Wandlers 11 geführt. Im Takt des Referenztakts R, der dem Digital-/Analog-Wandler 11 über dessen Eingang 12 zugeführt wird, wird die Folge von zeitdiskreten Sinusfunktionswerten in eine "treppenförmige" quasi-analoge sinusförmige Zeitfunktion im Innern des Digital-/Analog-Wandlers 11 gewandelt. Diese quasi-analoge sinusförmige Zeitfunktion wird am Ausgang 13 des Digital-/Analog-Wandlers 11 ausgegeben und über die Verbindungsleitung 14 dem Eingang 15 des Anti-Aliasing-Tiefpaßfilters 16 zugeführt.

Im Anti-Aliasing-Tiefpaßfilter 16 erfolgt eine Bandbegrenzung des vom Digital-/Analog-Wandler 11 erzeugten "treppenförmigen" Sinusfunktionssignals entsprechend dem Nyquistkriterium gemäß Beziehung (2):

$$f_A >= 2 * f_G \hspace{4cm} (2)$$

Am Ausgang 17 des Anti-Aliasing-Tiefpaßfilters 16 entsteht ein geglättetes Sinusfunktionssignal, indem das "treppenförmige" Sinusfunktionssignal am Eingang 15 des Anti-Aliasing-Tiefpaßfilters 16 in seiner Bandbreite auf die Grenzfrequenz $f_G$ begrenzt wird, die nach dem Nyquistkriterium kleiner als die halbe Abtastfrequenz $f_A$ sein muß. Dieses geglättete Sinusfunktionssignal stellt das vom direkten digitalen Frequenzsynthesizer erzeugte Ausgangsfrequenzsignal $F_{DDS}$ dar, dessen Frequenz sich aus Beziehung (1) ergibt.

Auf der Basis dieses direkten digitalen Frequenzsynthesizers von Fig. 3 nach dem Stand der Technik ist in Fig. 4 der erfindungsgemäße direkte digitale Frequenzsynthesizer dargestellt, wobei für gleiche Merkmale identische Bezugszeichen zu Fig. 3 verwendet werden.

Die von der Speichereinheit 6 an ihrem Ausgang 8 erzeugte Folge von zeitdiskreten Sinusfunktionswerten wird über eine Verbindungsleitung 9 einem, Eingang 18 einer Addiereinheit 19 zugeführt. In der Addiereinheit 19 wird im Takt eines am Eingang 20 anliegenden Referenztaktes R der Folge von zeitdiskreten Sinusfunktionswerten ein am Eingang 21 anliegendes Rauschsignal überlagert. Die Folge von zeitdiskreten Sinusfunktionswerten, die von einem Rauschsignal NS überlagert ist, wird am Ausgang 22 der Addiereinheit 19 ausgegeben und über die Verbindungsleitung 23 dem Eingang 10 des Digital-/Analog-Wandlers 11 zugeführt.

Das Rauschsignal N, das über eine Verbindungsleitung 24 dem Eingang 21 der Addiereinheit 19 zugeführt wird, wird von einem Rausch-Generator 25 erzeugt. An das Frequenzspektrum des Rauschsignals NS werden folgende Anforderungen gestellt:

- kein Gleichanteil im Rauschsignal NS, um einen unerwünschten Offset des aus zeitdiskreten Rauschsignal und zeitdiskreten Sinusfunktionswerten zusammengesetzten diskreten Frequenzsignals am Ausgang der Addiereinheit zu vermeiden,
- möglichst geringer Rauschpegel im Nutzsignalband im Hinblick auf einen guten Signal-Rausch-Abstand und
- möglichst geringer Rauschpegel im Niedrigstfrequenzbereich, um Intermodulationen zwischen niedrigstfrequenten Rauschsignalanteilen und der Trägerfrequenz im Hinblick auf unerwünschte Bildung von trägernahen Nebenlinien im Frequenzspektrum zu vermeiden.

Da es sich bei dem Rauschsignal NS um ein abgetastetes Signal handelt, erscheinen im Frequenzspektrum des Rauschsignals NS oberhalb der Nyquistgrenze ($0,5 * f_s$) periodische Wiederholungen des Frequenzspektrums in der 1. Nyquist-Zone. Da die Abtastfrequenz $f_s$ des Rauschsignals mit 25 MHz in unserem Beispiel in den Bereich des Nutzsignalbandes (zwischen 16 und 28 MHz) fällt, sind insbesondere die Spektralanteile des Rauschsignals an den Rändern der 1. Nyquist-Zone (beispielsweise bei 1 MHz oder bei 24 MHz) zu dämpfen. Hierzu wird ein digitales Filter verwendet, das zusätzlich die Abtastfrequenz $f_s$ des Rauschsignals mittels Interpolation um den Faktor 2, 4, 8 usw. erhöht (upsampling). Höherfrequente Spektralanteile im Rauschsignal aufgrund der Periodizitäten im Frequenzspektrum werden, um die Struktur des digitalen Filters nicht zu komplex zu gestalten, durch das Anti-Aliasing-Tiefpaßfilter 16 im Anschluß an den Digital-/Analog-Wandler 11 gefiltert.

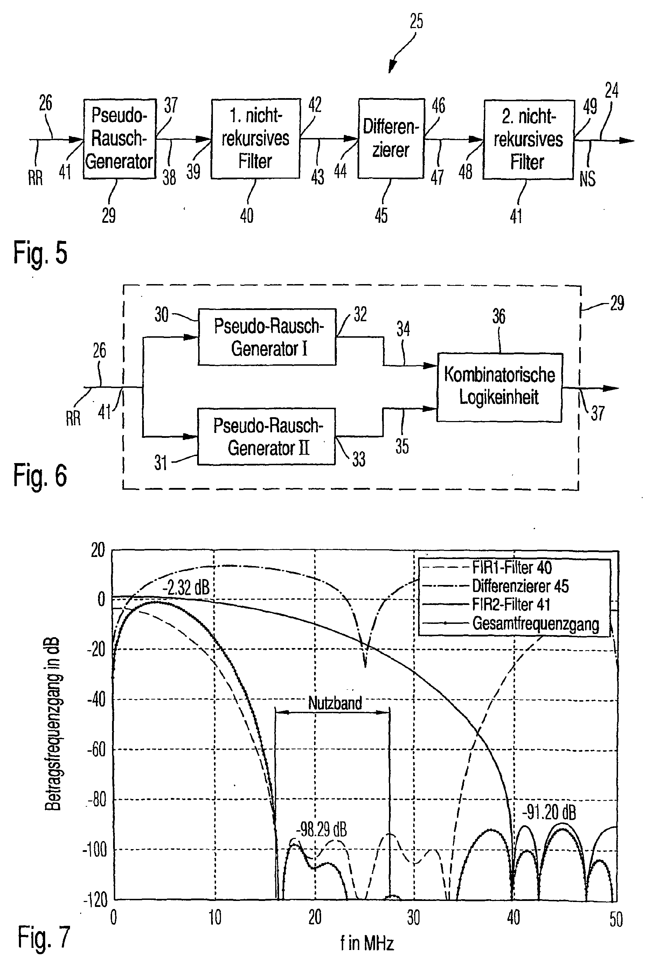

Im erfindungsgemäßen Rauschgenerator gem. Fig. 5 wird die Interpolation des zeitdiskreten Rauschsignals auf eine höhere Abtastfrequenz (upsampling) gleichzeitig mit der spektralen Ausbildung des Rauschsignals entsprechend den oben genannten drei Anforderungen in einer digitalen Filterstruktur realisiert. Da die Anforderungen an das Frequenzspektrum des Rauschsignals vergleichsweise komplex sind, wird diese Aufgabe im erfindungsgemäßen Rauschgenerator auf zwei digitale Filter verteilt. In jedem der beiden digitalen Filter erfolgt eine Interpolation des Rauschsignals auf eine jeweils doppelte Abtastfrequenz.

Um in der Addiereinheit 19 im Takt der Referenzfrequenz R den zeitdiskreten Sinusfunktionswerten ein Rauschsignal NS mit der gleichen Abtastfrequenz sinnvoll zuzuführen, ist auf Grund der Frequenzvervierfachung des Rauschsignals im Rauschgenerator 25 eine Taktung des Rauschgenerators 25 mit einer gegenüber der Referenzfrequenz R vierfach reduzierten Frequenz erforderlich. Diese vierfach gegenüber der Referenzfrequenz R reduzierte Taktungsfrequenz RR des Rauschgenerators 25 wird über einen Frequenzteiler 27 erzeugt, an dessen Eingang 28 das Referenzsignal R anliegt. Die gegenüber der Referenzfrequenz R vierfach reduzierte Taktungsfrequenz RR des Rauschgenerators 25 wird über die Verbindungsleitung 26 dem Rauschgenerator 25 vom Frequenzteiler 27 zugeführt.

Der Rauschgenerator 25 besteht gemäß Fig. 5 aus einem Pseudonoise-Rauschgenerator 29. Hierbei handelt es sich im allgemeinen um ein rückgekoppeltes Schieberegister, das vom z. B. vierfach gegenüber dem Referenztakt R reduzierten Taktungssignal RR am Eingang 41 gespeist wird. Durch die Rückkopplung des Schieberegisters ergibt sich am Ausgang des Schieberegisters eine endliche Folge von diskreten Abtastwerten, deren Signalpegel quasi stochastisch verteilt sind, aber eine Periodizität aufweisen.

Um diese Periodizität der diskreten Abtastwerte zu verlängern, besteht der Pseudonoise-Rauschgenerator 29 gemäß Fig. 6 vorzugsweise aus einer Parallelschaltung eines ersten Pseudonoise-Rauschgenerators 30 und eines zweiten Pseudonoise-Rauschgenerators 31, die beide über die Verbindungsleitung 26 am Eingang 41 von der vierfach gegenüber der Referenzfrequenz R reduzierten Taktungsfrequenz RR gespeist werden. Deren Ausgänge 32 und 33 werden über die Verbindungsleitung 34 und 35 mit der kombinatorischen Logik-Einheit 36 verbunden. Die kombinatorische Logik-Einheit 36 verknüpft die beiden Rauschsignale des Pseudonoise-Rauschgenerators 30 und 31, die beide einer Periodizität unterworfen sind, entsprechend einer kombinatorischen Verknüpfungslogik. Auf diese Weise entsteht am Ausgang 37 des Pseudonoise-Rauschgenerators 29 ein Rauschsignal, dessen Periodizitätsintervall gegenüber den Periodizitätsintervallen des ersten und zweiten Pseudonoise-Rauschgenerators 30 und 31 deutlich länger ist.

Über die Verbindungsleitung 38 wird dieses Rauschsignal dem Eingang 39 eines ersten nicht-rekursiven Filters 40 zugeführt. Im ersten nicht-rekursiven Filter 40 erfolgt eine Frequenzerhöhung des um den Faktor vier gegenüber der Referenzfrequenz R in seiner Frequenz reduzierten Rauschsignals um einen Faktor zwei mittels Interpolation. Neben einer Frequenzverdopplung des Rauschsignals mittels Interpolation führt das erste nicht-rekursive Filter 40 in Kombination mit dem zweiten nicht-rekursiven Filter 41 eine Filterung des Rauschsignals entsprechend den oben genannten drei Anforderungen an das Frequenzspektrum des Rauschsignals durch. Das Frequenzspektrum des ersten nicht-rekursiven Filters (FIR1-Filter) 40 weist gemäß Fig. 7 einen bandsperre-ähnlichen Frequenzverlauf (gestrichelte Linie) auf, der insbesondere im Bereich des Nutzsignalbandes - Frequenzbereichs beispielsweise zwischen 17 MHz und 28 MHz - ein stark dämpfendes Übertragungsverhalten besitzt.

Am Ausgang 42 des ersten nicht-rekursiven Filters 40 liegt aufgrund der Interpolation ein Rauschsignal mit der halben Referenzfrequenz vor. Dieses wird über die Verbindungsleitung 43 dem Eingang 44 eines Differenzierers 45 zugeführt. Im Differenzierer 45 erfolgt über eine einfache (oder mehrfache) Differenzenbildung des zeitdiskreten Rauschsignals eine Unterdrückung des Gleichanteils sowie niedrigstfrequenter Frequenzanteile im Rauschsignal. Der Frequenzgang des Differenzieres 45 ist in Fig. 7 dargestellt (strich-punktierte Linie) und weist nicht nur im niedrigsten Frequenzbereich, sondern auch im Bereich des Nutzsignalbandes bei ca. 25 MHz deutlich ausgeprägte Dämpfungsmaxima auf.

Das durch den Differenzierer 45 im wesentlichen differenzierte Rauschsignal wird am Ausgang 46 des Differenzierers 45 ausgegeben und über eine Verbindungsleitung 47 dem Eingang 48 des zweiten nicht-rekursiven Filters 41 zugeführt. Im zweiten nicht-rekursiven Filter 41 erfolgt eine Anhebung der Abtastfrequenz des gegenüber der Referenzfrequenz R in seiner Frequenz zweifach reduzierten Rauschsignals um den Faktor zwei mittels Interpolation, so daß am Ausgang 49 des zweiten nicht-rekursiven Filters 41 ein Rauschsignal anliegt, dessen Frequenz der Referenzfrequenz R entspricht. In Fig. 7 ist der Frequenzgang des zweiten nicht-rekursiven Filters (FIR-2-Filter) 41 dargestellt (durchgezogene Linie), welcher im wesentlichen eine Tiefpaßcharakteristik hat.

Die Kombination der Frequenzgänge des ersten nicht-rekursiven Filters 40, des Differenzierers 45 und des zweiten nicht-rekursiven Filters 41 ergibt den Gesamtfrequenzgang (durchgezogene Linie mit diskreten Punkten) der dem Pseudorauschgenerator 29 nachfolgenden digitalen Filterstruktur. Zu erkennen ist die klare Dämpfungscharakteristik im Frequenzursprung sowie in niedrigstfrequenten Bereich. Daneben im Frequenzbereich bis zum Nutzsignalband ist das Bandpaßverhalten der gesamten Filterstruktur zur Erzeugung eines niederfrequenten Rauschspektrums klar erkennbar. Im Bereich des Nutzsignalbandes erfolgt ein von allen drei digitalen Filtern 40, 41 und 45 gleichzeitig und vergleichsweise gleichmäßig über das gesamte Nutzsignalband realisiertes Dämpfungsverhalten zur Erzielung eines optimalen Signal-Rausch-Abstandes. Schließlich ist im hoch- bzw. höchstfrequenten Frequenzbereich oberhalb des Nutzsignalbandes ein ausreichendes Dämpfungsverhalten zur Beseitigung der Frequenzanteile des Rauschsignals ab der Nyquistgrenze erkennbar.

Im erfindungsgemäßen direkten digitalen Frequenzsynthesizer wird gemäß Fig. 4 das am Ausgang 17 des Anti-Aliasing-Tiefpaßfilters 16 anstehende geglättete Ausgangsfrequenzsignal über die Verbindungsleitung 50 dem Eingang 51 eines analogen Hochpaßfilters 52 zugeführt. In diesem analogen Hochpaßfilter 52 erfolgt die Trennung des verrauschten Ausgangsfrequenzsignals vom niederfrequenten Rauschsignal.

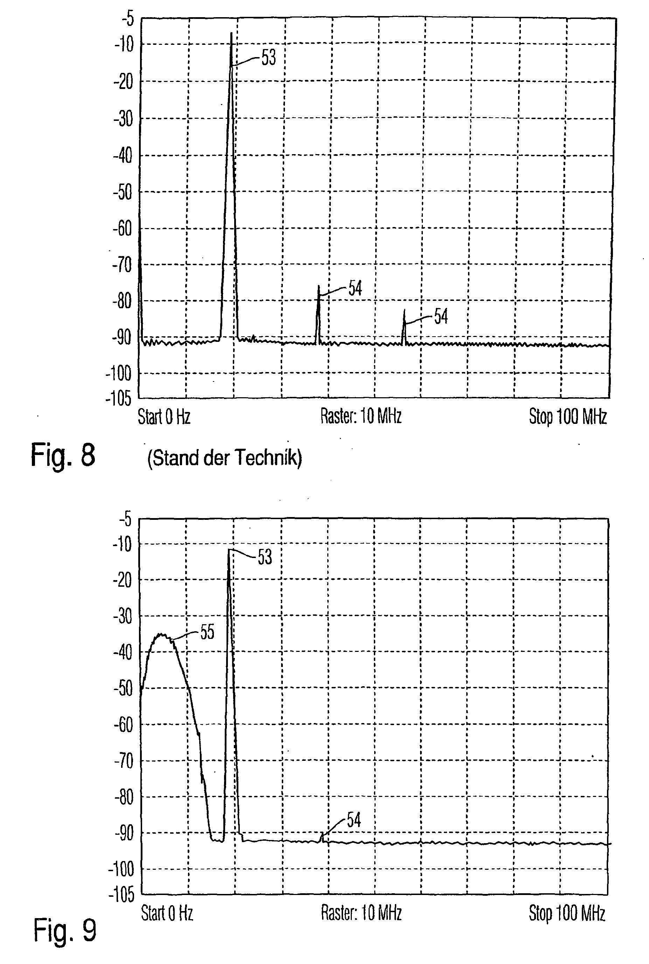

In Fig. 8 ist das Frequenzspektrum des Ausgangsfrequenzsignals des direkten digitalen Frequenzsynthesizer nach dem Stand der Technik, das am Ausgang 17 des Anti-Aliasing-Tiefpaßfilters 16 anliegt, ersichtlich. Zu erkennen ist der Nutzpegel 53 des Ausgangsfrequenzsignals $F_{DDS}$ bei einer Frequenz von 19 MHz, die vom direkten digitalen Frequenzsynthesizer bei einer Referenzfrequenz R von 100 MHz erzeugt wird. In der grafischen Darstellung der Fig. 8 sind die durch Nichtlinearitäten der Übertragungskennlinie sowie durch nicht optimales dynamisches Verhalten des Digital-/Analog-Wandlers 11 bedingten Nebenlinien 54 bei den Frequenzen 38 MHz und 57 MHz deutlich sichtbar. Der Nebenlinienabstand beträgt jeweils -70 dBc und -78 dBc.

In Fig. 9 ist dagegen das Frequenzspektrum des Ausgangsfrequenzsignals $F_{DDS}$ des erfindungsgemäßen diskreten digitalen Frequenzsynthesizers, das am Ausgang 17 des Anti-Aliasing-Tiefpaßfilters 16 anliegt, dargestellt. Im dargestellten Beispiel ist der aus zeitdiskreten Sinusfunktionswerten und zeitdiskretem Rauschsignal NS zusammengesetzte Signalpegel am Ausgang 22 der Addierereinheit 19 um einen einstellbaren Faktor zwei reduziert. Der Nutzpegel 53 des Ausgangsfrequenzsignals $F_{DDS}$ des erfindungsgemäßen direkten digitalen Frequenzsynthesizers in Fig. 9 ist deshalb gegenüber dem Nutzpegel 53 des Ausgangfrequenzsignals $F_{DDS}$ des direkten digitalen Frequenzsynthesizer nach dem Stand der Technik in Fig. 8 um 6 dB abgesenkt. Dieser Umstand verschlechtert den Signal-Rausch-Abstand des Ausgangsfrequenzsignals $F_{DDS}$ konsequenterweise auch um 6 dB. In Fig. 9 ist die deutliche Abschwächung der Nebenlinien zu erkennen (die Nebenlinie 54 des Ausgangsfrequenzsignals $F_{DDS}$ des erfindungsgemäßen diskreten digitalen Frequenzsynthesizers bei der Frequenz 38 MHz weist einen Nebenlinienabstand von -78dBc auf, die Nebenlinien 54 bei der Frequenz 55 MHz weisen einen Nebenlinienabstand < -80 dBc auf).

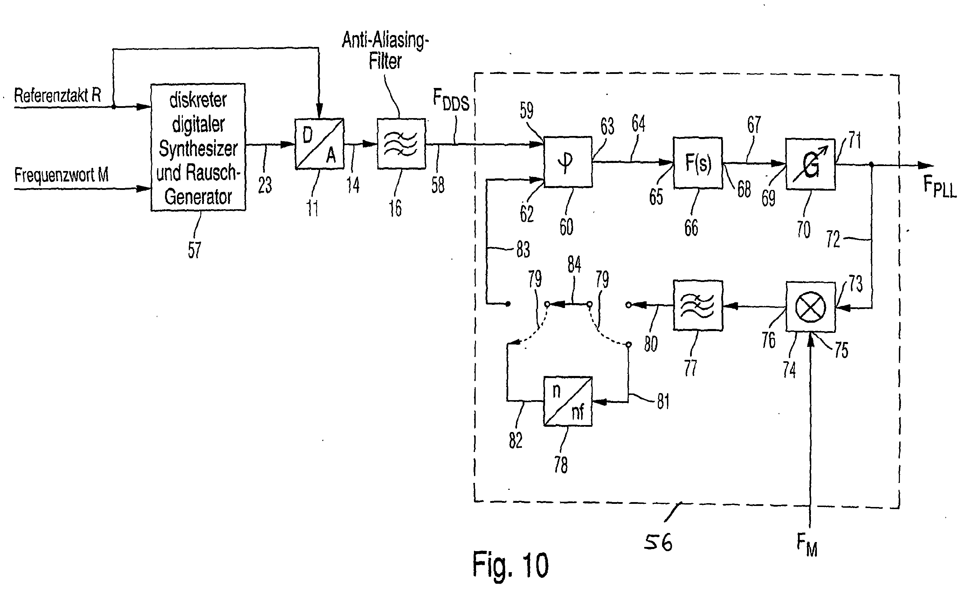

In Fig. 9 ist auch der niederfrequente Rauschsignalanteil 55 im Frequenzbereich zwischen 0 MHz und ca. 15 MHz erkennbar, der nachfolgend durch das analoge Hochpaßfilter 52 unterdrückt wird. Restrauschanteile im Ausgangsfrequenzsignal $F_{DDS}$ nach der Filterung durch das analoge Hochpaßfilter 52 werden durch einen nachfolgenden Phasenregelkreis 56 gemäß Fig. 10 gedämpft.

In der Gesamtdarstellung eines Frequenzsynthesizers gemäß Fig. 10 ist der erfindungsgemäße direkte digitale Frequenzsynthesizer und ein nachfolgender Phasenregelkreis 56 zu erkennen. Der direkte digitale Frequenzsynthesizer besteht gemäß Fig. 4 aus einer erfindungsgemäßen Einheit 57, die sich aus dem Phasenakkumulator 1, der Speichereinheit mit Sinustabelle 6, der Addiereinheit 19, dem Frequenzteiler 27 und dem Rauschgenerator 25 zusammensetzt, einem nachfolgenden Digital-/Analog-Wandler 11, einem Anti-Aliasing-Tiefpaßfilter 16 und einem in Fig. 10 nicht dargestellten analogen Hochpaßfilter 52.

Der Phasenregelkreis 56 hat die Aufgabe, das Ausgangsfrequenzsignal $F_{DDS}$ des erfindungsgemäßen direkten digitalen Frequenzsynthesizers am Ausgang 57 des analogen Hochpaßfilters 52 - im Bereich beispielsweise zwischen ca. 17 MHz und 28 MHz - auf ein Hochfrequenzsignal - im Bereich beispielsweise zwischen 900 MHz und 1,8 GHz - zu transformieren. Hierzu wird das Ausgangsfrequenzsignal $F_{DDS}$ über die Verbindungsleitung 58 als Referenzsignal dem ersten Eingang 59 eines Phasendetektors 60 zugeführt. An den zweiten Eingang 62 des Phasendetektors 60 wird das rückgekoppelte und evtl. frequenzgeteilte Ausgangsfrequenzsignal $F_{PLL}$ des Phasenregelkreises 56 zurückgeführt.

Im Phasendetektor 60 erfolgt die Bildung der Regeldifferenz aus dem als Referenzsignal dienenden Ausgangsfrequenzsignal $F_{DDS}$ des direkten digitalen Frequenzsynthesizers und dem rückgekoppelten und frequenzgeteilten Ausgangsfrequenzsignal $F_{PLL}$ des Phasenregelkreises 56. Diese Regeldifferenz am Ausgang 63 des Phasendetektors 60 wird über die Verbindungsleitung 64 dem Eingang 65 des Regelfilters 66 zugeführt. Im Regelfilter 66 erfolgt eine dynamische Bewertung der Regeldifferenz zur Erzielung eines optimalen dynamischen und stationären Regelverhaltens des Phasenregelkreises 56 (geringstmögliche Einschwingzeit, minimiertes Überschwingen, minimale stationäre Regelabweichung usw.). Auf diese Weise wird das Ausgangsfrequenzsignal $F_{PLL}$ des Phasenregelkreises 56 optimal dem als Referenzgröße dienenden Ausgangsfrequenzsignal $F_{DDS}$ des direkten digitalen Frequenzsynthesizers zur Frequenzdifferenzbildung rückgeführt.

Über die Verbindungsleitung 67 wird die am Ausgang 68 des Regelfilters 66 anliegende Ausgangsregelgröße dem Eingang 69 des spannungsgesteuerten Frequenzoszillators 70 zugeführt. Der spannungsgesteuerte Frequenzoszillator 70 erzeugt auf Basis der Ausgangsregelgröße das korrespondierende hochfrequente Ausgangfrequenzsignal $F_{PLL}$ am Ausgang 71.

Das am Ausgang 71 des spannungsgesteuerten Frequenzoszillators 70 anliegende Ausgangsfrequenzsignal $F_{PLL}$ wird dem ersten Eingang 73 des Mischers 74 über die Verbindungsleitung 72 zugeführt. Am zweiten Eingang 75 des Mischers 74 liegt ein spektral sehr reines Mischfrequenzsignal $F_M$ an, das in der gleichen Größenordnung wie das Ausgangsfrequenzsignal $F_{PLL}$ ist und nur in einem groben Frequenzraster eingestellt werden kann. Der Mischer 74 generiert an seinem Ausgang 76 ein Frequenzsignal, das der Differenz zwischen dem Ausgangsfrequenzsignal $F_{PLL}$ des Phasenregelkreises 56 und dem am Trägersignaleingang 75 anliegenden grob-rasterigen Mischfrequenzsignal $F_M$ entspricht. Auf diese Weise wird eine Frequenzreduzierung des Ausgangsfrequenzsignals $F_{PLL}$ des Phasenregelkreises 56 in Analogie zu einem Phasenregelkreis mit Frequenzteiler mit Rückkopplungszweig ohne die dabei nötige Frequenzdivision des Ausgangsfrequenzsignals um den Faktor N , die wie oben dargestellt zu einer deutlichen Erhöhung des Phasenrauschens am Ausgang des Phasenregelkreises führt, vorgenommen.

Das vom Mischer 74 an seinem Ausgang 76 ebenfalls erzeugte weitere Frequenzsignal, das der Summe zwischen dem Ausgangsfrequenzsignal $F_{PLL}$ des Phasenregelkreises 56 und dem am zweiten Eingang 75 anliegenden grob-rasterigen Mischfrequenzsignal $F_M$ entspricht, wird von einem dem Mischer 74 nachfolgenden Tiefpaßfilter 77 unterdrückt.

Das grobrasterige, spektral sehr reine Mischfrequenzsignal $F_M$ am zweiten Eingang 75 des Mischers 74 wird entweder über einen Frequenzvervielfacher aus einer spektral sehr reinen Festfrequenz oder mit Hilfe eines zweiten Phasenregelkreis erzeugt.

Das über den Mischer 74 umgesetzte Ausgangsfrequenzsignal $F_{PLL}$ des Phasenregelkreises 56 wird nach einer Tiefpaßfilterung mittels Tiefpaßfilter 77 über die Verbindungsleitungen 80 und 81 und einen Schalter 79 in der die Verbindungsleitung 80 und 81 miteinander verbindenden Schalterstellung einem Frequenzteiler 78 zugeführt. Dieser Frequenzteiler 78, der optional eingesetzt werden kann, führt nur noch eine Frequenzteilung des bereits durch den Mischer 74 umgesetzten Ausgangsfrequenzsignals $F_{PLL}$ im kleinen Umfang durch. Mit dem Einsatz des Frequenzteilers 78 kann die Umsetzung des Ausgangsfrequenzsignals $F_{PLL}$ des Phasenregelkreises entsprechend dem Teilungsfaktor des Frequenzteilers 78 gröber ausgelegt werden.

Über die Verbindungsleitungen 82 und 83 und den Schalter 79 in der die Verbindungsleitungen 82 und 83 miteinander verbindenden Schalterstellung wird das frequenzgeteilte Ausgangssignal des Frequenzteilers 78 an den zweiten Eingang 62 des Phasendetektors 60 geführt. Wird der Schalter 79 dagegen in der anderen Schalterstellung gehalten, so wird das frequenzreduzierte Ausgangssignal des Mischers 74 nach einer Tiefpaßfilterung mittels Tiefpaßfilter 77 ohne Frequenzteilung durch den Frequenzteiler 78 über die Verbindungsleitung 80, die Direktverbindung 84 und die Verbindungsleitung 83 dem zweiten Eingang 62 des Phasendetektor 60 zugeführt.

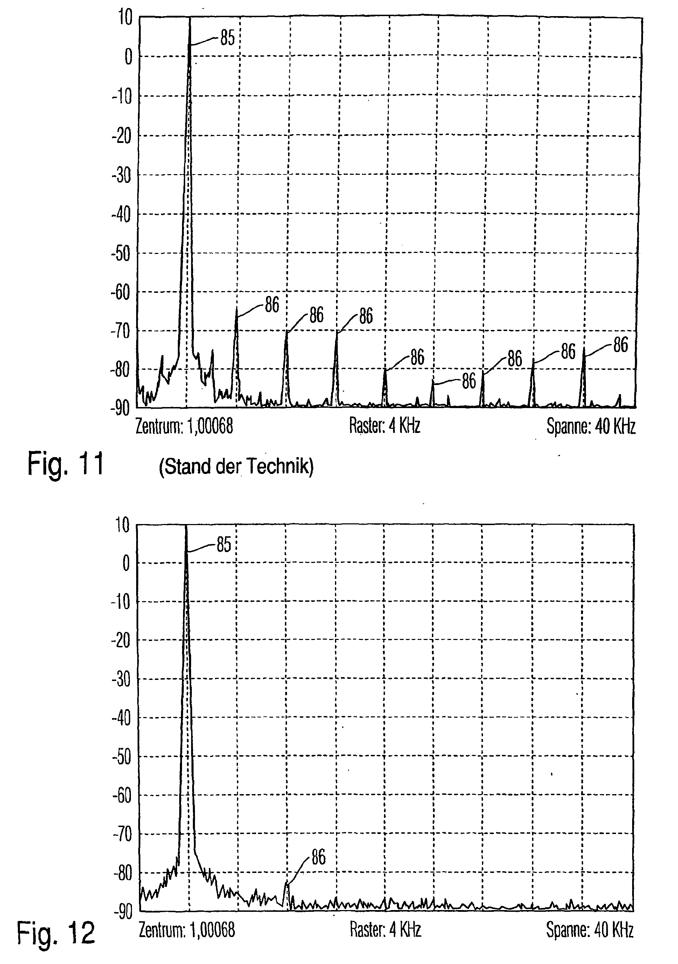

In Fig. 11 ist das Ausgangsfrequenzsignal $F_{PLL}$ des Phasenregelkreises 56 mit vorgeschaltetem direkten digitalen Frequenzsynthesizer nach dem Stand der Technik ohne Überlagerung der diskreten Sinusfunktionswerte mit einem diskreten Rauschsignal NS dargestellt. Das Ausgangsfrequenzsignal $F_{DDS}$ des direkten digitalen Frequenzsynthesizers wird bei einer Taktung des direkten digitalen Frequenzsynthesizers mit einer Referenzfrequenz von im dargestellten Beispiel 100 MHz auf eine Frequenz von 16,666 MHz eingestellt. Bei einer Einspeisung eines Mischfrequenzsignals $F_M$ von 934 MHz am Trägersignaleingang 75 des Modulators 74 und einer Frequenzteilung am Frequenzteiler 78 um den Faktor 4 ergibt sich ein Ausgangsfrequenzsignal $F_{PLL}$ des Phasenregelkreises 56 von 1,000664 GHz (934 MHz + 4 * 16,666 MHz = 1,000664 GHz).

Deutlich ist der Nutzpegel 85 dieses Ausgangsfrequenzsignal $F_{PLL}$ des Phasenregelkreises 56 bei der Frequenz 1,000664 GHz im Frequenzspektrum in Fig. 11 zu erkennen. Auch die Nebenlinien 86, die trägernah am Nutzpegel 85 bei den Frequenzen 1,000664 GHz + k * 4 kHz (k = 1,2,3,4,5 usw.) aufgrund vorhandener Nichtlinearitäten in der Übertragungskennlinie sowie nicht-idealer dynamischer Verhältnisse im Digital-/Analog-Wandler 11 auftreten, sind klar in Fig. 11 zu identifizieren. Die entsprechenden Nebenlinienabstände betragen jeweils -75dBc, -82dBc, - 83dBc, -95dBc, -90dBc, -93dBc, -89dBc und -87dBc.

Die Nebenlinien 86 im Frequenzspektrum des Ausgangsfrequenzsignals $F_{PLL}$ des Phasenregelkreises 56 liegen sehr trägernah an der Frequenz des Nutzsignalpegels (|f| < 1,000664 GHz + 50 kHz). Nach der Regeldifferenzbildung im Phasendetektor 60 liegen die Frequenzen der Nebenlinien am Eingang 65 des Regelfilters 66 in einem Frequenzbereich kleiner 50 kHz und werden von der Regeldynamik des Regelfilters 65, die die Regeldynamik des offenen Phasenregelkreises 56 - Amplituden- bzw. Phasendurchgangsfrequenz des offenen Phasenregelkreises 56 liegt in Größenordnungen von 500 kHz - im wesentlichen bestimmt, nicht unterdrückt.

In Fig. 12 ist dagegen das Ausgangsfrequenzsignal $F_{PLL}$ des Phasenregelkreises 56 mit vorgeschaltetem erfindungsgemäßen direkten digitalen Frequenzsynthesizer dargestellt. Zu erkennen ist der Nutzsignalpegel 85 bei einer Frequenz von 1,000664 GHz. Die Nebenlinien werden vergleichsweise gut unterdrückt. Die Nebenlinie 86 bei der Frequenz 1,000664 GHz + 8 kHz ist im Spektrum noch leicht zu erkennen. Ihr Nebenlinienabstand beträgt -93 dBc. Aufgrund der Frequenzteilung mit Faktor vier im Phasenregelkreis 56 ergibt sich für diese Nebenlinie ein Nebenlinienabstand von -105dBc bei Bezug zum Ausgangsfrequenzsignal $F_{DDS}$ des erfindungsgemäßen direkten digitalen Frequenzsynthesizers. Die restlichen Nebenlinien weisen alle einen Nebenlinienabstand > -100 dBc auf, was mit anderen direkten digitalen Frequenzsynthesizern mit nachgeschalteten Phasenregelkreis bisher noch nicht realisiert wurde.

**Patentansprüche**

1. Frequenzsynthesizer nach dem direkten digitalen Synthese-Verfahren, mit
   einem Phasenakkumulator (1) zum zyklischen Inkrementieren eines Phasensignals (P) um ein am Eingang (3) des Phasenakkumulators (1) anliegendes Phaseninkrement (M),
   einer Speichereinheit (6) mit einer in deren Speicherzellen abgespeicherten Tabelle von Sinusfunktionswerten zur Ermittlung von zu Phasenwerten des Phasensignals (P) korrespondierenden Sinusfunktionswerten, wobei der Phasenakkumulator (1) mit einer Referenzfrequenz (R) getaktet wird,
   einem Digital-/Analogwandler (11) zur Wandlung der zeitdiskreten Sinusfunktionswerte in eine treppenförmige, quasi analoge, sinusförmige Zeitfunktion,
   einem Anti-Aliasing-Tiefpaßfilter (16) zur Glättung der quasi analogen sinusförmigen Zeitfunktion,
   einem Rauschgenerator zum Erzeugen eines Rauschsignals (NS), und
   einer Addiereinheit (19), die zwischen der Speichereinheit (6) und dem Digital-/Analog-Wandler (11) zwischengeschaltet ist, wobei in der Addiereinheit (19) den zeitdiskreten Sinusfunktionswerten das Rauschsignal (NS) überlagert wird,
   **dadurch gekennzeichnet,**
   **daß** der Rauschgenerator (25)
   einen Pseudonoise-Rauschgenerator (29) zur Erzeugung eines Rauschsignals mit einer gegenüber der Referenzfrequenz (R) mehrfach reduzierten Taktfrequenz,
   ein erstes nicht-rekursives Filter (40) zur Interpolation eines vom Pseudonoise-Rauschgenerator (29) erzeugten Rauschsignals auf ein Rauschsignal mit einer gegenüber der Referenzfrequenz (R) mehrfach reduzierten Taktfrequenz,
   einen Differenzierer (45) zur Filterung eines Gleichanteils und niederfrequenter Anteile aus dem vom ersten nicht-rekursiven Filter (40) erzeugten Rauschsignal und
   ein zweites nicht-rekursives Filter (41) zur Interpolation des vom Differenzierer (45) erzeugten Rauschsignals auf ein Rauschsignal mit einer der Referenzfrequenz (R) entsprechenden Taktfrequenz,
   aufweist.

2. Frequenzsynthesizer nach Anspruch 1,
   **dadurch gekennzeichnet,**
   **daß** das Rauschsignal (NS) ein im Niederfrequenzbereich bandpaßgefiltertes Rauschsignal ist.

3. Frequenzsynthesizer nach Anspruch 2,

**dadurch gekennzeichnet,**
**daß** der Phasenakkumulator (1), die Speichereinheit (6), die Addiereinheit (19) und der Digital-/Analogwandler (11) von der gemeinsamen Referenzfrequenz (R) synchron getaktet sind.

**4.** Frequenzsynthesizer nach Anspruch 3,
**dadurch gekennzeichnet,**
**daß** das im Niederfrequenzbereich bandpaßgefilterte Rauschsignal von dem Rauschgenerator (25) erzeugt wird, der von einem frequenzgeteilten Referenztakt (RR) angesteuert wird, der aus der gemeinsamen Referenzfrequenz (R) unter Zwischenschaltung eines Frequenzteilers (27) gewonnen wird.

**5.** Frequenzsynthesizer nach Anspruch 4,
**dadurch gekennzeichnet,**
**daß** der frequenzgeteilte Referenztakt (RR) eine gegenüber der gemeinsamen Referenzfrequenz (R) mehrfach reduzierte Frequenz aufweist.

**6.** Frequenzsynthesizer nach Anspruch 4 oder 5,
**dadurch gekennzeichnet,**
**daß** die Frequenz des frequenzgeteilten Referenztaktes (RR) und die Frequenzbegrenzung des vom Pseudonoise-Rauschgenerator (29) erzeugten Rauschsignals vierfach und die Frequenzbegrenzung des vom ersten nicht-rekursiven Filter (40) erzeugten Rauschsignals zweifach reduziert gegenüber der gemeinsamen Referenzfrequenz (R) ist.

**7.** Frequenzsynthesizer nach Anspruch 1,
**dadurch gekennzeichnet,**
**daß** der Pseudonoise-Rauschgenerator (29) aus zwei parallel geschalteten Pseudonoise-Rauschgeneratoren (30, 31) besteht, deren Ausgänge (32, 33) über eine kombinatorische Logik-Einheit (36) miteinander verknüpft sind.

**8.** Frequenzsynthesizer nach Anspruch 3,
**dadurch gekennzeichnet,**
**daß** dem Anti-Aliasing-Tiefpaßfilter (16) ein analoges Hochpaßfilter (52) zur Unterdrückung des im Niederfrequenzbereich bandpaßgefilterte Rauschsignals in einem Ausgangssignal des Anti-Aliasing-Tiefpaßfilters (16) nachfolgt.

**9.** Frequenzsynthesizer nach Anspruch 8,
**dadurch gekennzeichnet,**
**daß** der Ausgang (57) des analogen Hochpaßfilters (52) an den ersten Eingang (59) eines Phasenregelkreises (56) geführt ist.

**10.** Frequenzsynthesizer nach Anspruch 9,
**dadurch gekennzeichnet,**
**daß** der Phasenregelkreis (56)
einen Phasendetektor (60) zur Ermittlung der Regeldifferenz zwischen einem am Ausgang (57) des analogen Hochpaßfilters (52) anliegenden Ausgangsfrequenzsignal ($F_{DDS}$) des Frequenzsynthesizers und einem frequenzgeteilten Ausgangsfrequenzsignal ($F_{PLL}$) des Phasenregelkreises (56),
ein Regelfilter (66) zur dynamischen Bewertung der am Ausgang (63) des Phasendetektors (60) anliegenden Regeldifferenz,
einen spannungsgesteuerten Frequenzoszillator (70) zur Erzeugung eines Ausgangsfrequenzsignals ($F_{PLL}$) in Abhängigkeit von einem Ausgangssignal des Regelfilters (66),
einen Mischer (74) sowie einen nachgeschalteten Tiefpaß (77) zur groben Umsetzung des Ausgangsfrequenzsignals ($F_{PLL}$) um den Wert eines am Mischer (74) anliegenden, grob-rasterigen Mischfrequenzsignals ($F_M$),
aufweist.

**11.** Frequenzsynthesizer nach Anspruch 10,
**dadurch gekennzeichnet,**
**daß** dem Mischer (74) ein Frequenzteiler (78) zur Frequenzteilung des durch den Mischer (74) grob umgesetzten Ausgangsfrequenzsignals ($F_{PLL}$) und ein Schalterelement (79), über das der Frequenzteiler (78) über eine Direktverbindung (84) überbrückbar ist, nachgeschaltet ist.

**12.** Frequenzsynthesizer nach Anspruch 10 oder 11,
**dadurch gekennzeichnet,**

**daß** das dem Mischer (74) des Phasenregelkreises (56) zugeführte grob-rasterige Mischfrequenzsignal ($F_M$) von einem zweiten Phasenregelkreis oder durch Umsetzung aus der gemeinsamen Referenzfrequenz (R) erzeugt wird.

**Claims**

1. Frequency synthesiser according to the direct-digital-synthesis method comprising a phase accumulator (1) for the cyclical incrementation of a phase signal (P) by a phase increment (M) present at the input (3) of the phase accumulator (1), with a memory unit (6) containing a table of sine-function values stored in its memory cells for the determination of sine-function values corresponding to phase values of the phase signal (P), wherein the phase accumulator (1) is timed with a reference frequency (R),
with a digital-to-analogue converter (11) for the conversion of the time-discrete sine-function values into a stepped, quasi-analogue sinusoidal time function,
an anti-aliasing low-pass filter (16) for smoothing the quasi-analogue sinusoidal time function,
a noise generator for generating a noise signal (NS), and
an adder (19), which is connected between the memory unit (6) and the digital/analogue converter (11), wherein the noise signal (NS) is superimposed over the time-discrete sinusoidal values in the adder (19),
**characterised in that**
the noise generator (25) provides a pseudo-noise generator (29) for generating noise signal with a clock-pulse frequency reduced many times by comparison with the reference frequency (R),
a first non-recursive filter (40) for the interpolation of a noise signal generated by the pseudo-noise noise generator (29) into a noise signal with a clock-pulse frequency reduced many times by comparison with the reference frequency (R),
a differentiator (45) for filtering a direct component and relatively-lower frequency components from the noise signal generated by the first non-recursive filter (40)
and
a second non-recursive filter (41) for the interpolation of the noise signal generated by the differentiator (45) into a noise signal with a clock-pulse frequency corresponding to the reference frequency (R).

2. Frequency synthesiser according to claim 1,
**characterised in that**
the noise signal (NS) is a noise signal bandpass-filtered in the low-frequency range.

3. Frequency synthesiser according to claim 2,
**characterised in that**
the phase accumulator (1), the memory unit (6), the adder (19) and the digital-to-analogue converter (11) are timed synchronously with the common reference frequency (R).

4. Frequency synthesiser according to claim 3,
**characterised in that**
the noise signal bandpass-filtered in the low-frequency range is generated by the noise generator (25), which is controlled with a frequency-divided reference clock pulse (RR) obtained from the common reference frequency (R) by the interconnection of a frequency divider (27).

5. Frequency synthesiser according to claim 4
**characterised in that**
the frequency-divided reference clock pulse (RR) provides a frequency reduced many times by comparison with the common reference frequency (R).

6. Frequency synthesiser according to claim 4 or 5,
**characterised in that**
the frequency of the frequency-divided reference clock pulse (RR) and the frequency limiting of the noise signal generated by the pseudo-noise generator (29) is reduced four times by comparison with the common reference frequency (R), and the frequency limiting of the noise signal generated by the first non-recursive filter (40) is reduced twice by comparison with the common reference frequency (R).

7. Frequency synthesiser according to claim 1,
**characterised in that**

the pseudo-noise generator (29) consists of two parallel-connected pseudo-noise generators (30, 31), of which the outputs (32, 33) are interconnected via a combinatorial logic unit (36).

8. Frequency synthesiser according to claim 3,
   **characterised in that**
   the anti-aliasing low-pass filter (16) is followed by an analogue high-pass filter (52) for the suppression of the noise signal bandpass-filtered in the low-frequency range in an output signal of the anti-aliasing low-pass filter (16).

9. Frequency synthesiser according to claim 8,
   **characterised in that**
   the output (57) of the analogue high-pass filter (52) is supplied to the first input (59) of a phase-locked loop (56).

10. Frequency synthesiser according to claim 9,
    **characterised in that**
    the phase-locked loop (56) provides
    a phase detector (60) for determining the system deviation between an output frequency signal ($F_{DDS}$) of the frequency synthesiser present at the output (57) of the analogue high-pass filter (52) and a frequency-divided output frequency signal ($F_{PLL}$) of the phase-locked loop (56),
    a control filter (66) for the dynamic evaluation of the system deviation present at the output (63) of the phase detector (60),
    a voltage-controlled frequency oscillator (70) for generating an output frequency signal ($F_{PLL}$) dependent upon an output signal of the control filter (66),
    a mixer (74) and a series-connected low-pass filter (77) for the coarse conversion of the output frequency signal ($F_{PLL}$) by the value of a coarse-grid mixed-frequency signal ($F_M$) present in the mixer (74).

11. Frequency synthesiser according to claim 10,
    **characterised in that**
    a frequency divider (78) for frequency division of the output frequency signal ($F_{PLL}$) coarsely converted by the mixer (74) and a switching element (79), across which the frequency divider (78) can be bridged via a direct connection (84), is connected downstream of the mixer (74).

12. Frequency synthesiser according to claim 10 or 11,
    **characterised in that**
    the coarse-grid mixed-frequency signal ($F_M$) supplied to the mixer (74) of the phase-locked loop (56) is generated by a second phase-locked loop or by conversion from the common reference frequency (R).

**Revendications**

1. Synthétiseur de fréquence basé sur le procédé de synthèse numérique directe comprenant
   un accumulateur de phase (1) servant à l'incrémentation cyclique d'un signal de phase (P) d'un incrément de phase (M) appliqué à l'entrée (3) de l'accumulateur de phase (1),
   une unité de mémoire (6) dans les cellules de laquelle est stockée une table de valeurs de fonction sinus servant à déterminer les valeurs de fonction sinus correspondant à des valeurs de phase du signal de phase (P), l'accumulateur de phase (1) étant cadencé avec une fréquence de référence (R),
   un convertisseur numérique-analogique (11) servant à convertir les valeurs de fonction sinus à temps discret en une fonction de temps sinusoïdale quasi-analogique en forme d'escalier,
   un filtre passe-bas anti-repliement (16) servant à lisser la fonction de temps sinusoïdale quasi-analogique,
   un générateur de bruit servant à produire un signal de bruit (NS), et
   une unité d'addition (19) qui est intercalée entre l'unité de mémoire (6) et le convertisseur numérique-analogique (11), le signal de bruit (NS) étant superposé aux valeurs de fonction sinus à temps discret dans l'unité d'addition (19),
   **caracterisé en ce que**
   le générateur de bruit (25) comprend
   un générateur de pseudo-bruit (29) servant à produire un signal de bruit avec une fréquence d'horloge réduite plusieurs fois par rapport à la fréquence de référence (R), un premier filtre non récursif (40) servant à l'interpolation d'un signal de bruit produit par le générateur de pseudo-bruit (29) sur un signal de bruit avec une fréquence d'horloge réduite plusieurs fois par rapport à la fréquence de référence (R), un amplificateur différenciateur (45) servant à la filtration d'une composante continue et de composantes à basse fréquence à partir du signal de bruit produit par le premier filtre non récursif (40) et
un second filtre non récursif (41) servant à l'interpolation du signal de bruit produit par l'amplificateur différenciateur (45) sur un signal de bruit avec une fréquence d'horloge correspondant à la fréquence de référence (R).

2. Synthétiseur de fréquence selon ta revendication 1,
**caractérisé en ce**
**que** le signal de bruit (NS) est un signal de bruit filtré par un filtre passe-bande dans la gamme de basse fréquence.

3. Synthétiseur de fréquence selon la revendication 2,
**caractérisé en ce**
**que** l'accumulateur de phase (1), l'unité de mémoire (6), l'unité d'addition (19) et le convertisseur numérique analogique (11) sont cadencés de manière synchrone par la fréquence de référence (R) commune.

4. Synthétiseur de fréquence selon la revendication 3,
**caractérisé en ce**
**que** le signal de bruit filtré par un filtre passe-bande dans la gamme de basse fréquence est produit par le générateur de bruit (25) qui est commandé par une horloge de référence (RR) divisée en fréquence, laquelle est obtenue à partir de la fréquence de référence (R) commune en intercalant un diviseur de fréquence (27).

5. Synthétiseur de fréquence selon la revendication 4,
**caractérisé en ce**
**que** l'horloge de référence (RR) divisée en fréquence comprend une fréquence réduite plusieurs fois par rapport à la fréquence de référence (R) commune.

6. Synthétiseur de fréquence selon la revendication 4 ou 5,
**caractérisé en ce**
**que** la fréquence de l'horloge de référence (RR) divisée en fréquence et la limite de fréquence du signal de bruit produit par le générateur de pseudo-bruit (29) sont réduites quatre fois et la limite de fréquence du signal de bruit produit par le premier filtre non récursif (40) est réduite deux fois par rapport à la fréquence de référence (R) commune.

7. Synthétiseur de fréquence selon la revendication 1,
**caractérisé en ce**
**que** le générateur de pseudo-bruit (29) est constitué de deux générateurs de pseudo-bruit (30, 31) branchés en parallèle, dont les sorties (32, 33) sont reliées l'une à l'autre par le biais d'une unité logique combinatoire (36).

8. Synthétiseur de fréquence selon la revendication 3,
**caractérisé en ce**
**que** en aval du filtre passe-bas anti-repliement (16), se trouve un filtre passe-haut analogique (52) servant à la suppression du signal de bruit filtre par un filtre passe-bande dans la gamme de basse fréquence dans un signal de sortie du filtre passe-bas anti-repliement (16).

9. Synthétiseur de fréquence selon la revendication 8,
**caractérisé en ce**
**que** la sotie (57) du filtre passe-haut analogique (52) conduit à la première entrée (59) d'un circuit boucle à verrouillage de phase (56).

10. Synthétiseur de fréquence selon la revendication 9,
**caractérisé en ce**
**que** le circuit boucle à verrouillage de phase (56) comprend
un détecteur de phases (60) servant à déterminer l'écart de statisme entre un signal de fréquence de sortie ($F_{DDS}$) du synthétiseur de fréquence appliqué à la sortie du filtre passe-haut analogique (52) et un signal de fréquence de sortie ($F_{PLL}$) divisé en fréquence du circuit boucle à verrouillage de phase (56),
un filtre de boucle (66) permettant l'évaluation dynamique de l'écart de statisme appliqué à la sortie (63) du détecteur de phases (60),
un oscillateur de fréquence piloté en tension (70) servant à la production d'un signal de fréquence de sortie ($F_{PLL}$) en fonction d'un signal de sortie du filtre de boucle (66), un mélangeur (74), ainsi qu'un passe-bas (77) situe en aval, permettant la conversion approximative du signal de fréquence de sortie ($F_{PLL}$) de la valeur d'un signal de fréquence de mélange ($F_M$) grossier se trouvant au niveau du mélangeur (74).

**11.** Synthétiseur de fréquence selon la revendication 10,
**caractérisé en ce**
**que,** en aval du mélangeur (74), se trouve un diviseur de fréquence (78) servant à diviser la fréquence du signal de fréquence de sortie ($F_{PLL}$) converti de manière approximative à l'aide du mélangeur (74) et un élément de couplage (79), par le biais duquel le diviseur de fréquence (78) peut être relié via une liaison directe (84).

**12.** Synthétiseur de fréquence (78) selon la revendication 10 ou 11,
**caractérisé en ce**
**que** le signal de fréquence de mélange ($F_M$) grossior transmis au mélangeur (74) ducircuit boucle à verrouillage de phase (56) est produit par un second circuit boucle à verrouillage de phase ou par une conversion à partir de la fréquence de référence (R) commune.

Fig. 1

Fig. 2

Fig. 3
(Stand der Technik)

Referenztakt R

Frequenzwort M

Phasen-akku-mulator
1

Speicher-Einheit mit Sinustabelle
6

D-/A-Wandler
11

Anti-Aliasing-Tiefpaßfilter
16

$F_{DDS}$

Fig. 4

Referenztakt R

Frequenzwort M

Phasen-akku-mulator
1

Speicher-Einheit mit Sinustabelle
6

Frequenz-teiler

Rauschgenerator, Filter, Interpolator

D-/A-Wandler
11

Anti-Aliasing-Tiefpaßfilter
16

Hoch-paßfilter

$F_{DDS}$

Fig. 5

Fig. 6

Fig. 7

Fig. 8     (Stand der Technik)

Fig. 9

Fig. 10

**Fig. 11**      (Stand der Technik)

Zentrum: 1,00068      Raster: 4 KHz      Spanne: 40 KHz

**Fig. 12**      Zentrum: 1,00068      Raster: 4 KHz      Spanne: 40 KHz

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0469233 A2
- US 4901265 A
- US 2002057733 A1

**In der Beschreibung aufgeführte Nicht-Patentliteratur**

- **PAPAY.** Numerical Distortion in Single-Tone DDS. *IEEE-Instrumentation and Measurement Technology Conference,* 21. Mai 2001